Europäisches Patentamt

European Patent Office

Office européen des brevets

(19)

(11) **EP 1 235 355 A2**

(12) **DEMANDE DE BREVET EUROPEEN**

(43) Date de publication:
**28.08.2002 Bulletin 2002/35**

(51) Int Cl.[7]: **H04B 1/12**, H03D 3/00,
H03H 9/46

(21) Numéro de dépôt: **02290373.6**

(22) Date de dépôt: **15.02.2002**

(84) Etats contractants désignés:
**AT BE CH CY DE DK ES FI FR GB GR IE IT LI LU
MC NL PT SE TR**
Etats d'extension désignés:
**AL LT LV MK RO SI**

(30) Priorité: **26.02.2001 FR 0102587**

(71) Demandeur: STMicroelectronics S.A.
**92120 Montrouge (FR)**

(72) Inventeurs:
• **Giry-Cassan, Florence**
**38000 Grenoble (FR)**
• **Ravatin, Jean**
**38430 Moirans (FR)**

(74) Mandataire: **Casalonga, Axel**
**BUREAU D.A. CASALONGA - JOSSE**
**Paul-Heyse-Strasse 33**
**80336 München (DE)**

(54) **Procédé et dispositif de compensation du décalage CC dynamique d'un récepteur à conversion directe**

(57) Système et procédé de compensation du décalage variable de valeur continue d'un récepteur à conversion directe, comprenant un moyen 10 pour déterminer une variable représentative de signaux d'interférence en fonction de la fréquence à partir d'un signal reçu et démodulé dans un canal d'une bande de fréquence de réception dans un système de radiocommunication pour obtenir une compensation en fonction de la fréquence.

## FIG.1

**Description**

La présente invention relève du domaine des récepteurs à conversion directe, dans lesquels on cherche à éliminer la composante continue dynamique.

Dans un récepteur à conversion directe ou homodyne, les signaux radiofréquence sont convertis directement en signaux de bande de base.

Les avantages de la technique de conversion directe également appelée ZIF (pour Zero Intermediate Frequency en langue anglaise) sont multiples :

. La fréquence image a dans cette architecture la même puissance que le signal voulu (problème de réjection de la fréquence image grandement diminué : le filtre RF ne filtre plus cette fréquence)

. Le filtre passe-bande se transforme en un filtre passe-bas (intégrable donc peu cher, meilleure sélectivité que le passe-bande, plus performant)

. Les étages de gain travaillent à très basse fréquence, donc consomment moins et sont plus performants.

Mais elle présente aussi des inconvénients :

. La fréquence LO est dans la bande de réception donc devient un brouilleur potentiel. Il faut donc surveiller les radiations électromagnétiques de l'oscillateur local LO.

. Le bruit de scintillation ou de basse fréquence, dit 1/f car sa densité spectrale évolue approximativement comme l'inverse de la fréquence, se superpose au signal.

. Distorsions. Le récepteur ZIF est plus sensible aux non linéarités d'ordre 2 et 3.

. L'offset DC notamment dû au désappairage des composants tels que résistances et transistors bipolaires ou Mos, au mélange LO-LO entre le signal LO présent sur une borne LO et celui non voulu présent sur une borne RF, au mélange RF-RF entre le signal RF présent sur une borne RF et celui non voulu présent sur une borne LO, perturbe et dégrade la réception. Il est aussi bien statique que dynamique.

En effet, le mélangeur du récepteur reçoit en plus du signal voulu haute fréquence également des signaux haute fréquence de canaux adjacents qui créent, en raison des caractéristiques du mélangeur qui ne sont pas idéales, une composante dynamique de décalage continu ou décalage CC dynamique (dynamic DC offset en langue anglaise) perturbant à la sortie du mélangeur. Ainsi, des signaux forts de canaux adjacents peuvent produire un décalage CC dynamique substantiellement plus élevé que le signal souhaité dans le canal de réception.

Dans un récepteur numérique, un offset DC dynamique génère un décalage en x et y de la constellation, qui perturbe fortement le démodulateur dans sa prise de décision. Constellation est le nom donné à la représentation graphique de la modulation. La constellation donne tous les symboles possibles de la modulation dans un diagramme où le signal I est représenté sur l'axe des X et diagramme où le signal Q est représenté sur l'axe des Y. En GMSK, il y a quatre symboles et en 8-PSK huit symboles. La prise de décision a lieu par reconnaissance de l'information reçue et association avec un des symboles de la constellation.

Il est possible de prévoir une étape de correction logique des erreurs d'offset DC à partir du moment où celles-ci restent suffisamment longtemps stables en faisant par exemple une moyenne glissante.

Le document EP-A-0 806 841 décrit une méthode de compensation du décalage CC dynamique dans un récepteur à conversion directe par un signal reçu et démodulé dans l'un des canaux de la bande de fréquence de réception d'un système de radiocommunication. Un signal de correction est produit à partir des signaux des canaux de la bande de fréquence de réception. Le signal de correction est combiné avec le signal démodulé. La compensation ne dépend pas de la fréquence du signal perturbateur. Cela implique donc que l'on ne peut avoir le filtre en sortie du premier mélangeur, or celui-ci est utile pour éviter que les bloqueurs 3 MHz ne saturent les étages suivants. Les bloqueurs sont des interféreurs ou signaux non voulus qui ont une fréquence au minimum à 3 MHz de la porteuse mais dans la bande de fréquence prévue par la norme correspondante, par exemple GSM ou DCS/PCS. Les interféreurs possibles sont décrits dans la norme.

On sait d'après la Conférence intitulée "WMH : RF front end architectures, plus particulièrement la présentation intitulée "Direct Conversion Receivers - Expectations and Experiences", de Monsieur Hans-Joachim Jentschel, de l'Université Technique de Dresde, que l'offset CC dynamique est le problème le plus sérieux rencontré dans les récepteurs à conversion directe. On peut distinguer entre l'offset CC statique et dynamique. L'offset CC dynamique est causé essentiellement par le mélange RF-RF ou CO-CO. Il en résulte un signal continu de valeur dépendant du temps et qui cause un décentrage du signal de bande de base variable dans le temps. L'offset CC dynamique est plus difficile à corriger que l'offset CC statique. Il est impossible de distinguer l'offset CC dynamique et la part utile du signal de bande de base et il n'existe donc pas d'algorithme puissant pour ôter l'offset CC dynamique du signal de bande de base. L'auteur recommande donc d'éviter l'émergence de l'offset CC dynamique, ce qui peut être obtenu par une conception appropriée des composants, évitant les non-linéarités et le couplage des chemins des signaux.

La présente invention propose un système et un procédé remédiant aux inconvénients évoqués ci-dessus.

La présente invention propose une correction variable dans le temps et auto-adaptative du décalage CC dynamique dans un récepteur à conversion directe.

Le procédé de compensation, selon un aspect de l'invention, est destiné au décalage CC dynamique d'un signal reçu et démodulé dans un canal d'une bande de fréquence de réception dans un système de radiocommunication dans un récepteur à conversion directe. On détermine une variable représentative de signaux d'interférence en fonction de la fréquence pour obtenir une compensation en fonction de la fréquence. Ce procédé est intéressant vu que les bloqueurs sont obtenus de façon différente par le filtre. Il faut donc déterminer leur fréquence et compenser l'atténuation appliquée par ledit filtre lors de la correction.

Avantageusement, on calcule un signal de correction à partir de ladite variable et on combine le signal de correction et le signal démodulé.

Avantageusement, le signal de correction est élaboré en appliquant une fonction d'auto-corrélation à ladite variable.

Dans un mode de réalisation de l'invention, on filtre le signal reçu et démodulé dans un filtre passe-bas de fréquence de coupure Fc.

Avantageusement, on applique un gain en sortie de la fonction d'auto-corrélation, le gain étant calculé en fonction de la fréquence de coupure du filtre passe-bas. On peut ainsi bénéficier d'un signal de correction adapté au décalage CC dynamique quelle que soit la fréquence. Le gain peut également être calculé en fonction d'un gain estimé, de l'atténuation du filtre passe-bas et du gain en tension de la voie directe.

Le système de compensation du décalage CC dynamique d'un récepteur à conversion directe, selon un aspect de l'invention, comprend un moyen pour déterminer une variable représentative de signaux d'interférence en fonction de la fréquence à partir d'un signal reçu et démodulé dans un canal d'une bande de fréquence de réception dans un système de radiocommunication pour obtenir une compensation en fonction de la fréquence.

Dans un mode de réalisation de l'invention, le dispositif comprend un filtre passe-haut, un convertisseur analogique numérique, une mémoire, un module d'auto-corrélation et un module de calcul du signal de correction. Ces différents éléments constituent ce qu'on appelle "la voie indirecte" ou "la voie de correction". Le dispositif comprend également un sommateur du signal de correction et d'un signal issu de la voie directe dans laquelle est traité le signal reçu.

Dans un mode de réalisation de l'invention, la voie directe comprend un filtre passe-bas de fréquence de coupure Fc et d'atténuation AF, un amplificateur à gain programmable, un convertisseur analogique numérique et une mémoire. Un filtre passe-bas peut, en outre être disposé entre l'amplificateur et le convertisseur.

L'invention permet une compensation adaptative et de haute qualité du décalage CC dynamique, très gênant dans un récepteur à conversion directe et généré à l'intérieur du mélangeur par le mélange de signaux RF. Ce décalage est susceptible de perturber de façon significative le démodulateur, particulièrement dans le cas de la modulation 8-PSK.

Grâce à l'invention, la correction est adaptée à chaque type de signal brouilleur et est précise, indépendamment du nombre et du type de brouilleur. Ceci signifie que la correction est convenablement adaptée en permanence.

La présente invention sera mieux comprise à l'étude de la description détaillée de deux modes de réalisation pris à titre d'exemples nullement limitatifs et illustrés par les dessins annexés, sur lesquels :

- la figure 1 est une vue schématique d'un circuit selon un premier mode de réalisation de l'invention; et
- la figure 2 est une vue schématique d'un circuit selon un second mode de réalisation de l'invention.

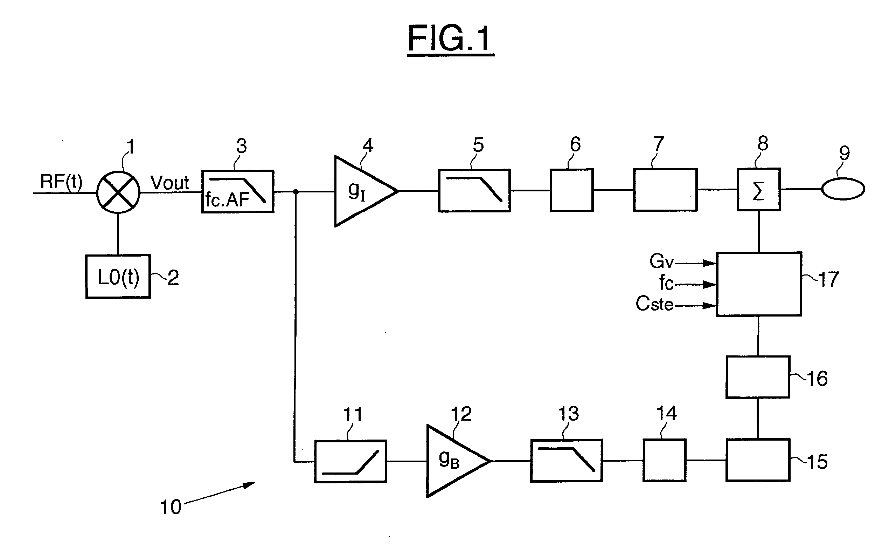

Comme on peut le voir sur la figure 1, un dispositif selon un mode de réalisation de l'invention comprend un mélangeur 1 recevant en entrée un signal RF(t) issu d'une antenne, non représentée, et ayant éventuellement été traité par un filtre passe-bande et/ou par un amplificateur HF à faible bruit. Une autre entrée du mélangeur 1 reçoit un signal LO(t), par exemple un signal carré, en provenance d'un oscillateur local 2. En sortie du mélangeur 1, est émis un signal $V_{out}(t)$ envoyé à un filtre passe-bas 3 du dispositif, par exemple un filtre du premier ordre d'atténuation AF et de fréquence de coupure $f_c$. La sortie du filtre passe-bas 3 est reliée à un amplificateur 4 à gain programmable $g_i$. La sortie de l'amplificateur 4 est reliée à un filtre passe-bas 5. La sortie du filtre passe-bas 5 est reliée à un convertisseur analogique numérique 6. La sortie du convertisseur analogique numérique 6 est reliée à une mémoire 7. Enfin, la sortie de la mémoire 7 est reliée à un sommateur 8 dont la sortie 9 forme la sortie du dispositif. Les éléments 1 à 7 forment la voie dite "directe" de traitement du signal RF.

Le dispositif comprend également une voie dite "indirecte" référencée 10 dans son ensemble et comprenant un filtre passe-haut 11 dont l'entrée est reliée à la sortie du filtre passe-bas 3 de la voie directe. La sortie du filtre passe-haut 11 est reliée à un amplificateur 12 de gain $g_B$, par exemple constant. La sortie de l'amplificateur 12 est reliée à un filtre passe-bas 13. La sortie du filtre 13 est reliée à un convertisseur analogique numérique 14 dont la sortie est reliée à une mémoire 15. La sortie de la mémoire 15 est reliée à un module de calcul 16 apte à mettre en oeuvre une fonction d'auto-corrélation. La sortie du module de calcul 16 est reliée à un module 17 de calcul de gain dont la sortie est envoyée en entrée du sommateur 8. Le module de calcul 16 pourra être réalisé de façon logicielle ou de façon matérielle. Le module de calcul du gain 17 sera réalisé préférablement de façon logicielle.

Le signal LO issu de l'oscillateur local 2 sera de forme carrée et pourra s'écrire :

$$LO(t) \;=\; \sum_{n=1}^{\infty} B_n \; \cos \; nw_c t$$

avec

$$B_n = 2 \, \mathrm{sinc}\frac{n}{2}$$

On considère le signal RF composé d'un signal voulu V(t) et d'un signal parasite également appelé "brouilleur" B(t). On a donc RF(t)=V(t)+B(t). On part de l'hypothèse qu'il existe une isolation $I_{sol}$ entre l'entrée RF et l'entrée LO du mélangeur 1 et que cette isolation est réelle uniquement (sans composante imaginaire). On a donc :

$$LO(t) = \sum_{n=1}^{\infty} B_n \; \cos \; nw_c t \;+\; \frac{RF(t)}{I_{sol}}$$

A la sortie du mélangeur, nous obtenons

$$
\begin{aligned}
V_{out}(t) \;&=\; G_{the} \left( \sum_{n=1}^{\infty} B_n \; \cos \; nw_c t \;+\; \frac{RF(t)}{I_{sol}} \right) \; x \; RF(t) \\
&=\; G_{the} \sum_{n=1}^{\infty} B_n \; \cos \; nw_c t \; V(t) \;+\; G_{the} \sum_{n=1}^{\infty} B_n \; \cos \; nw_c t \; B(t) \\
&+\; G_{the} \, \frac{RF^2(t)}{I_{sol}} \; avec \; B_n \;=\; 2 \; \mathrm{sinc} \; \frac{n}{2}
\end{aligned}
$$

et

$$G_{the} = RF^2 \, (t)/I_{sol}.$$

Le filtre passe-bas 3 permet de limiter la dynamique à la sortie du mélangeur 1. Le filtre passe-bas 3 pourrait être un filtre RC du premier ordre, qui permettra d'atténuer les brouilleurs qui ont déjà généré le décalage CC dynamique de valeur

$$\left( \frac{1}{2} \; A_2^{\,2} \; \frac{G_{the}}{I_{sol}} \right)$$

On a donc

$$V_{out}(t) = \frac{1}{2} A_1 \frac{4}{\pi} \cos[(w_c - w_v)t] \, G_{the}$$

$$+ \frac{1}{2} \frac{A_2}{AF(f_B)} \frac{4}{\pi} \cos[(w_c - w_B)t] \, G_{the} + \frac{1}{2} A_2{}^2 \frac{G_{the}}{I_{sol}}$$

$f_B$ étant la fréquence d'un brouilleur, $f_v$ la fréquence du signal voulu V(t), $w_c = 2\pi f_c$, $w_v = 2\pi f_v$ et $w_B = 2\pi f_B$ où

$$AF(f_B) = \frac{1}{\sqrt{1 + f_B/f_c}} \text{ avec } f_c = \frac{1}{2\pi RC}$$

On veut supprimer ce terme $\frac{1}{2} A_2{}^2 \frac{G_{the}}{I_{sol}}$.
Il faut donc à partir du signal qui reste

$$\frac{1}{2} \frac{A_2}{AF(f_B)} \frac{4}{\pi} \cos[(w_c - w_B)t] \, G_{the}$$

recréer $\frac{1}{2} A_2{}^2 \frac{G_{the}}{I_{sol}}$

Le filtre passe-haut 11 permet de ne conserver que les brouilleurs notés B(t). L'amplificateur 12 de gain $g_B$ amplifie le signal B(t) de façon que l'on masque le bruit et que l'on envoie en entrée du convertisseur analogique numérique 14 de la voie « indirecte » un signal de niveau convenable. Le filtre passe-bas 13 est ajouté pour éviter le repliement de spectre également appelé aliasing.

La fonction d'auto-corrélation assurée par le module de calcul 16 s'écrit sur un signal sinusoïdal de la façon suivante :

$$\varphi_B(T) = \frac{A_2{}^2}{2} \cos(2\pi f T)$$

donc pour $T = 0$, on extrait $\frac{A_2{}^2}{2}$,
puis pour $\varphi_B(T) = 0$, on extrait $f$.
Avant le convertisseur 14, on a :

$$\frac{1}{2} \frac{A_2}{AF_{PB}(f_B) \, AF_{PH}(f_B)} \frac{4}{\pi} \, Gv_1 \, G_{the} \cos[(w_c - w_B)t]$$

Après le module de calcul 16, on a :

$$\frac{1}{2} \left( \frac{1}{2} \frac{A_2}{AF_{PB}(f_B) \, AF_{PH}(f_B)} \frac{4}{\pi} \, Gv_1 \, G_{the} \right)^2 \cos(2\pi (f_c - f_B)t)$$

On veut :

$$\frac{1}{2} \, G_{the} \frac{A_2{}^2}{I_{sol}} \text{ Gain entre la sortie du mélangeur 1 et l'entrée du sommateur 8}$$

$$= \frac{1}{2} \left( \frac{1}{2} \frac{A_2}{AF_{PB}(f_B) \, AF_{PH}(f_B)} \frac{4}{\pi} \, Gv_1 \, G_{the} \right)^2 \times Gv_{correction}$$

On en déduit :

$$Gv_{correction} = \frac{4 \; Gain \; AF_{PB}{}^2 \; (f_B) \; AF_{PH}{}^2 \; (f_B)}{\left(\dfrac{4}{\pi}\right)^2 Gv_1{}^2 \; G_{the} \; I_{sol}}$$

Les gains $G_{v1}$, $G_{the}$ sont à extraire au moment des mesures de production ainsi que le gain « Gain ».

Les atténuations $AF_{PB}$, $AF_{PH}$ sont à déduire après plusieurs points de mesure en production. Le terme $I_{sol}$ est constant et peut être mesuré en sortie de production. L'étalonnage convenable du circuit est réalisé en effectuant lors de la production des mesures de plusieurs niveaux de brouilleurs à la sortie de la voie indirecte pour établir la fréquence de coupure $f_c$ et l'atténuation AF, ainsi que le gain de la voie directe $G_{v1}$ et les constantes du circuit.

En d'autres termes, le filtre passe-haut 11 permet de rejeter le signal utile pour la voie indirecte et de conserver les brouilleurs. Le module de calcul 16 génère le carré des brouilleurs. Le module de calcul de gain 17 ajuste la valeur de correction pour compenser convenablement le décalage CC dynamique.

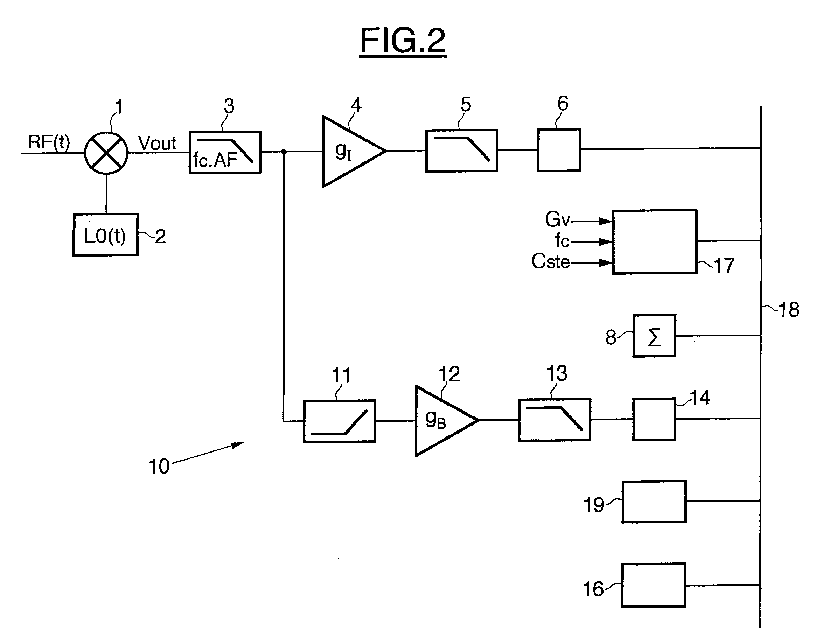

Sur la figure 2, est illustré un autre mode de réalisation dans lequel la sortie des convertisseurs analogique/ numérique 6 et 14 est reliée à un bus de communication 18 auquel sont également reliés le sommateur 8, le module de calcul 16 de fonction d'auto-corrélation, le module de calcul de gain 17 et une mémoire 19 apte à remplir la fonction des mémoires 7 et 15 du mode de réalisation illustré sur la figure 1.

L'invention est bien adaptée au récepteur à conversion directe à modulation 8-PSK ou encore à modulation GMSK.

Grâce à l'invention, on dispose un circuit de compensation de l'offset CC dynamique, fournissant une compensation en fonction de la fréquence et permettant donc de disposer d'un signal corrigé indépendamment de la fréquence. La correction est donc adaptée à chaque brouilleur et est précise quels que soient leur nombre et leur type. On obtient donc un signal de bien meilleure qualité qu'avec les récepteurs de l'art antérieur.

## Revendications

1. Procédé de compensation du décalage variable de valeur continue d'un signal reçu et démodulé dans un canal d'une bande de fréquence de réception dans un système de radiocommunication dans un récepteur à conversion directe, dans lequel on détermine une variable représentative de signaux d'interférences en fonction de la fréquence pour obtenir une compensation en fonction de la fréquence.

2. Procédé selon la revendication 1, dans lequel on calcule un signal de correction à partir de ladite variable et on combine le signal de correction et le signal démodulé.

3. Procédé selon la revendication 1 ou 2, dans lequel un signal de correction est élaboré en appliquant une fonction d'auto corrélation à ladite variable.

4. Procédé selon la revendication 3, dans lequel on applique un gain en sortie de la fonction d'auto corrélation, le gain étant calculé en fonction de la fréquence de coupure du filtre passe-bas, d'un gain estimé, de l'atténuation du filtre passe-bas et du gain en tension de la voie directe.

5. Procédé selon l'une quelconque des revendications précédentes, dans lequel on filtre le signal reçu et démodulé dans un filtre passe-bas de fréquence de coupure $f_c$.

6. Dispositif de compensation du décalage variable de valeur continue d'un récepteur à conversion directe, **caractérisé par le fait qu'**il comprend un moyen (10) pour déterminer une variable représentative de signaux d'interférences en fonction de la fréquence à partir d'un signal reçu et démodulé dans un canal d'une bande de fréquence de réception dans un système de radiocommunication, pour obtenir une compensation en fonction de la fréquence.

7. Dispositif selon la revendication 6 **caractérisé par le fait qu'**il comprend un filtre passe-haut (11), un convertisseur analogique numérique (14), une mémoire (15), un module d'auto corrélation (16), un module de calcul du signal de correction (17), et un sommateur (8) du signal de correction et d'un signal issu d'une voie directe.

8. Dispositif selon la revendication 7, **caractérisé par le fait qu'**il comprend un amplificateur (12) à gain constant disposé en aval du filtre passe-haut (11), et un filtre passe-bas (13) disposé en amont du convertisseur analogique numérique (1a).

**9.** Dispositif selon la revendication 7 ou 8, **caractérisé par le fait que** la voie directe comprend un filtre passe-bas (3) de fréquence de coupure $f_c$ et d'atténuation AF, un amplificateur (4) à gain programmable, un convertisseur analogique numérique (6) et une mémoire (7).

**10.** Dispositif selon la revendication 9, **caractérisé par le fait que** la voie directe comprend un filtre passe-bas disposé entre l'amplificateur et le convertisseur analogique numérique.

# FIG.1

EP 1 235 355 A2

# FIG.2